(19) Europäisches Patentamt / European Patent Office / Office européen des brevets

(11) **EP 1 679 795 B1**

(12) **FASCICULE DE BREVET EUROPEEN**

(45) Date de publication et mention
de la délivrance du brevet:
**26.10.2016 Bulletin 2016/43**

(51) Int Cl.:
***H03H 11/04*** *(2006.01)*

(21) Numéro de dépôt: **05405007.5**

(22) Date de dépôt: **10.01.2005**

(54) **Structure de polarisation pour filtre à temps continu**

Struktur einer Ruhestromschaltung für zeitkontinuierliche Filter

Biasing circuit structure for continuous time filters

(84) Etats contractants désignés:
**CH DE FR GB LI**

(43) Date de publication de la demande:
**12.07.2006 Bulletin 2006/28**

(73) Titulaire: **CSEM Centre Suisse d'Electronique et de**
**Microtechnique SA - Recherche et**
**Développement**
**2007 Neuchâtel (CH)**

(72) Inventeurs:
• **Melly, Thierry**
**1005 Lausanne (FR)**
• **Krummenacher, François**
**1610 Châtillens (CH)**
• **Peiris, Vincent**
**2025 Chez-le-Bart (CH)**

(74) Mandataire: **GLN SA**
**Avenue Edouard-Dubois 20**
**2000 Neuchâtel (CH)**

(56) Documents cités:
**EP-A- 0 766 385        US-A- 6 144 249**
**US-B1- 6 191 637        US-B1- 6 407 623**
**US-B1- 6 784 725**

**Description**

La présente invention se rapporte au domaine de l'électronique. Elle concerne plus précisément un circuit de polarisation intégré, pour des filtres à temps continu à base de blocs transconducteurs.

Un filtre à temps continu est un circuit électronique utilisé pour ajuster automatiquement une fréquence de coupure. Il trouve des applications dans tout dispositif nécessitant le filtrage de fréquence, par exemple pour la sélection d'un canal radio. Dans l'état actuel de la technique, il se compose de blocs transconducteurs (ou OTAs : Operational Transconductor Amplifiers) de transconductance $g_m$, combinés avec des charges capacitives de capacité C. Quel que soit l'agencement des transconducteurs et des charges capacitives, la fréquence de coupure $f_c$ du filtre est reliée à la transconductance $g_m$ et à la capacité C par une relation de proportionnalité :

$$f_c \propto g_m/C. \qquad (1)$$

Ainsi, la précision de la fréquence de coupure $f_c$ est liée à la précision des valeurs de transconductance $g_m$ et de capacité C, ou d'un couple R-C équivalent, la transconductance $g_m$ dépendant elle-même, par construction, d'une valeur de résistance R.

Or, le procédé CMOS de fabrication des résistances et des capacités intégrées est tel que la précision absolue pour ces éléments est de l'ordre de 15%. A celà s'ajoute la dépendance en température typique d'un procédé CMOS standard et affectant la résistance et la transconductance. Il en résulte que la valeur de la fréquence de coupure $f_c$ est connue avec une précision de l'ordre de 30%, ce qui est inacceptable pour la majorité des applications.

Plusieurs solutions existent actuellement afin de résoudre ce problème, mais toutes présentent un certain nombre d'inconvénients.

Une première approche consiste à asservir la valeur de la transconductance $g_m$ des OTAs à celle d'une résistance externe $R_{ext}$ dont la valeur est connue avec une précision de l'ordre de 1%. Pour cela, on utilise une réplique d'un OTA, montée en configuration de contre-réaction, ou 'feedback', associée à une résistance extérieure $R_{ext}$, afin d'asservir les transconductances $g_m$ des OTAs du filtre. Dans ce cas, la transconductance $g_m$ est directement proportionnelle à la résistance extérieure $R_{ext}$ :

$$g_m \propto 1/R_{ext}.$$

La précision de la fréquence de coupure $f_c$ est alors limitée par celle de la valeur absolue de la capacité C, qui est de l'ordre de 15%. Cependant, les variations en température des valeurs $R_{ext}$ et C demeurent. Par ailleurs, la présence d'un composant externe peut se révéler incompatible avec des applications hautement intégrées ou bon marché.

Une seconde méthode permet un asservissement précis de la fréquence de coupure $f_c$, pour autant qu'une fréquence de référence $f_{réf}$ soit disponible. Elle consiste à remplacer la résistance extérieure $R_{ext}$ par une 'capacité-commutée' intégrée $C_{sc}$ équivalente à une résistance $R_{sc}$. Dans ce cas, la résistance $R_{sc}$ s'exprime en fonction de la fréquence de référence $f_{réf}$ et de la capacité $C_{sc}$ :

$$R_{sc} = 1/(f_{réf}C_{sc}).$$

La relation de proportionnalité entre la fréquence de coupure $f_c$, la capacité C et la transconductance $g_m$ devient :

$$f_c \propto (f_{réf}C_{sc})/C.$$

Or, si les valeurs absolues des capacités C et $C_{sc}$ sont données avec une précision de 15%, le rapport des valeurs $C_{sc}/C$ peut être obtenu avec une précision de 1%. La fréquence de coupure peut, dès lors, être obtenue avec une grande précision.

Une autre méthode, employant une fréquence de référence stable, consiste à utiliser un oscillateur harmonique, de fréquence d'oscillation $f_{osc}$, et composé de transconducteurs et de charges capacitives caractérisés, respectivement, par leur transconductance $g_m$, identique à celle du filtre, et leur capacité $C_0$. La transconductance $g_m$ est asservie, grâce à une boucle de comparaison de phase, de sorte que la fréquence d'oscillation $f_{osc}$ prend la valeur de la fréquence de référence $f_{réf}$. Il existe alors une relation de proportionnalité entre la transconductance $g_m$, la fréquence de référence $f_{réf}$ et la capacité $C_0$ :

$$g_m \propto f_{\text{réf}} C_0.$$

En remplaçant la transconductance $g_m$ dans la relation (1), il ressort que la fréquence de coupure du filtre $f_c$ est elle même proportionnelle au rapport $f_{\text{réf}} C_0$ sur la capacité C du filtre :

$$f_c \propto (f_{\text{réf}} C_0)/C.$$

La fréquence de référence étant connue avec précision et le rapport $C_0/C$ étant obtenu avec une précision de 1%, la fréquence de coupure est elle-même déterminée avec une grande précision dans ce type de montage.

Toutefois, ces deux dernières solutions et, en particulier, la solution faisant intervenir un oscillateur harmonique, nécessitent une surface importante sur le circuit intégré, puisque toutes deux font appel à un ou plusieurs OTAs supplémentaires par rapport aux OTAs du filtre. En outre, toutes deux présentent une structure en boucle, donc une structure par définition moins stable et moins robuste qu'une structure non bouclée.

La présente invention propose une approche permettant de pallier ces inconvénients en offrant un circuit et une technique stables et compacts permettant d'ajuster automatiquement la fréquence de coupure de filtres à temps continu intégrés, pour autant qu'une fréquence de référence stable soit disponible.

Plus précisément, l'invention concerne un circuit intégré formant un filtre à temps continu destiné à ajuster automatiquement une fréquence de coupure $f_c$, comportant au moins un bloc transconducteur (OTA) de transconductance $g_m$, au moins une charge capacitive de capacité C couplée à la sortie dudit bloc, et une structure de polarisation destinée à délivrer un courant $I_b$ nécessaire au fonctionnement du bloc transconducteur et disposant d'un signal d'horloge de fréquence $f_{\text{réf}}$. Ce circuit est caractérisé en ce que la structure de polarisation est une structure de type 'proportionnelle à la température absolue' (en anglais 'Proportional to Absolute Temperature' ou PTAT) à capacité commutée.

Le circuit selon l'invention comporte encore les caractéristiques suivantes :

- la structure de polarisation est, par construction, agencée de manière à délivrer un courant $I_b$ proportionnel à la température absolue ;
- cette structure de polarisation comporte :

  - un premier transistor dont la grille est reliée au drain et un deuxième transistor identique au premier, lesdits transistors étant reliés par leurs grilles,
  - un miroir de courant réalisé au moyen d'un premier transistor dont la grille est reliée au drain, d'un deuxième transistor constitué de k transistors identiques au premier, et d'un troisième transistor identique au premier,
  - une structure à capacité commutée composée de deux transistors identiques dont les grilles sont reliées au signal d'une horloge et d'une charge capacitive, ladite structure étant équivalente à une résistance de valeur $R_{sc}$, et
  - une charge capacitive

- le bloc transconducteur comporte :

  - deux dispositifs de transconductance identiques, reliés par leurs sources,
  - un premier miroir de courant comportant une entrée et deux sorties et composé de trois transistors identiques, et
  - un deuxième miroir de courant comportant deux transistors identiques.

- le circuit comporte une pluralité de blocs transconducteurs et de charges capacitives couplées à chacun d'eux de manière à former un filtre, lesdits blocs recevant le courant $I_b$ généré par la structure de polarisation.

D'autres caractéristiques de l'invention ressortiront de la description qui va suivre, faite en regard de la figure unique annexée.

Le circuit, selon l'invention, associe au moins un bloc transconducteur 1, de type OTA, couplé à une charge capacitive 2 pour former un filtre de fréquence de coupure $f_c$, vérifiant la relation (1), à une structure de polarisation 3 de type PTAT à capacité commutée.

Plus précisément, un OTA 1, convertissant une tension d'entrée $V_{in}$ en un courant de sortie $I_{out}$, est asservi par un PTAT 3 à capacité commutée, fournissant un courant de polarisation $I_b$ stable, nécessaire au fonctionnement de l'OTA 1.

La structure de l'OTA 1, tout comme celle du bloc de polarisation PTAT 3, sont bien connues de l'homme de métier. L'association de ces deux structures, en combinaison avec la charge capacitive 2, permet d'obtenir un filtre de fréquence de coupure $f_c$ ne dépendant que d'une fréquence de référence $f_{réf}$ et d'un rapport de capacités.

Dans un mode de réalisation simple, la structure de polarisation PTAT 3 est constituée d'un miroir de courant 4, d'une charge capacitive 5 de capacité $C_{s1}$, d'une structure à capacité commutée 6 équivalente à une résistance $R_{sc}$ et de deux transistors PMOS 7 et 8.

Les miroirs de courant sont bien connus de l'homme de métier et comportent une entrée et au moins une sortie. Leur fonction consiste à garantir que le courant en sortie du miroir est égal, à un facteur multiplicatif k près, au courant à l'entrée du miroir. Ils sont généralement constitués d'au moins deux transistors, reliés par leur grille, la grille de l'un d'eux étant reliée à son drain, les sources étant mises au même potentiel. Si les deux transistors sont identiques, le facteur multiplicatif est 1. Si les deux transistors sont différents en taille, le facteur multiplicatif est différent de 1. Une manière bien connue d'augmenter la taille d'un transistor est de lui connecter en parallèle d'autres transistors identiques.

Le miroir de courant 4 est constitué de trois transistors NMOS 9, 10 et 11, les grilles des trois transistors étant reliées ensemble, leurs sources étant reliées à la masse et le drain du transistor 10 étant relié à sa grille. Le drain du transistor 10 constitue l'entrée E du miroir de courant 4, tandis que les drains des transistors 9 et 11 constituent ses sorties S. Les transistors 10 et 11 sont identiques, de sorte que le gain en courant en sortie du transistor 11 vaut 1. Par contre, le transistor 9 est constitué de k transistors identiques au transistor 10, de sorte que le gain en courant pour cette sortie vaut k.

La structure à capacité commutée 6 est constituée d'une charge capacitive 12 et de deux transistors PMOS identiques 13 et 14 dont les grilles reçoivent respectivement les signaux ck et ck d'une horloge. La source du transistor 14 est reliée au drain du transistor 13 dont la source est elle-même reliée à une tension d'alimentation $V_{DD}$, typiquement de l'ordre de 0.9 à 1.8V. La charge capacitive 12 de capacité $C_{s0}$ est branchée entre la source et le drain du transistor 13. La résistance équivalente $R_{sc}$ de cette structure à capacité commutée est fonction uniquement de la fréquence de l'horloge $f_{réf}$ et de la capacité $C_{s0}$ :

$$R_{sc} = 1/(C_{s0}f_{réf}). \qquad (2)$$

Les deux transistors PMOS 7 et 8 sont identiques et dimensionnés pour une utilisation en forte inversion. Ils sont reliés ensemble par leur grille, la grille du transistor 7 étant reliée à son drain. La source de ce transistor est reliée à la tension d'alimentation $V_{DD}$, tandis que la source du transistor 8 est reliée au drain du transistor 14. Par ailleurs, le drain du transistor 8 est relié au drain du transistor 10, tandis que le drain du transistor 7 est relié au drain du transistor 9.

Enfin, la charge capacitive 5 est branchée entre les sources des transistors 7 et 8 et sert à filtrer la tension d'alimentation $V_{DD}$.

Par construction de la structure PTAT 3 qui vient d'être décrite, le courant $I_b$ circulant à travers le transistor 8 ne dépend que des dimensions des transistors 7 et 8, de la technologie de fabrication et de la résistance équivalente $R_{sc}$ du circuit à capacité commutée :

$$I_b = (1/R_{sc})^2(2n_p/\beta_2)(k^{1/2}-1)^2. \qquad (3)$$

Dans cette équation, $n_p$ est un facteur de pente qui dépend uniquement de la technologie de fabrication, $\beta_2$ est le facteur de forme des transistors 7 et 8 et dépend uniquement de leurs dimensions et k est une constante.

Le courant $I_b$ est, de par les propriétés du miroir de courant 4, égal au courant $I_b$ circulant à travers le transistor 11. Par construction du circuit, il est aussi le courant de polarisation de l'OTA 1, comme décrit par la suite.

Selon un mode de réalisation bien connu, l'OTA 1 comprend deux transistors ou 'dispositifs de transconductance' 15 et 16, constituant la partie active de l'OTA 1, dimensionnés pour une utilisation en forte inversion et identiques aux transistors 7 et 8 de la structure de polarisation 3, et deux miroirs de courant 17 et 18.

Les deux transistors PMOS 15 et 16 sont reliés ensemble par leurs sources et sont reliés d'une part au miroir de courant 18 et, d'autre part, au miroir de courant 17, comme décrit par la suite.

Le miroir de courant 17 est constitué de deux transistors NMOS identiques 19 et 20, reliés ensemble par leurs grilles, le drain du transistor 19 étant relié à sa grille et les sources des transistors 19 et 20 étant mises à la terre. Les drains des transistors 15 et 16 sont reliés respectivement à l'entrée E du miroir de courant 17, c'est à dire au drain du transistor 19 et à la sortie du miroir de courant 17, c'est à dire au drain du transistor 20.

Le miroir de courant 18 a pour fonction de distribuer le courant à l'OTA 1 et est constitué de trois transistors PMOS identiques 21, 22, 23, formant une entrée E et deux sorties S. Les trois transistors 21, 22 et 23 sont reliés ensemble par leurs grilles et leurs sources sont reliées à la tension d'alimentation $V_{DD}$. Le drain du transistor 23, formant l'entrée E du miroir de courant 18, est relié à sa grille et les drains des transistors 21 et 22, formant les sorties S dudit miroir de courant, sont reliés aux sources, respectivement des transistors 15 et 16.

Une tension d'entrée $V_{in}$ est appliquée entre les grilles des transistors 15 et 16 formant l'entrée de l'OTA 1 et un courant de sortie $I_{out}$ est prélevé par l'intermédiaire d'un noeud 24 formant la sortie de l'OTA 1 et situé entre les drains des transistors 16 et 22.

La charge capacitive 2 est connectée au noeud 24.

Par construction, le courant de polarisation, aux sorties S du miroir de courant 18, est égal au courant en entrée du même miroir de courant. Or, le bloc transconducteur 1 ainsi décrit est asservi par le courant $I_b$ fourni par la structure de polarisation PTAT 3 décrite précédemment, les drains des transistors 11 et 23 étant reliés ensemble. Par conséquent, le courant circulant en sortie S des transistors 21 et 22 est égal au courant $I_b$ donné par la relation (3).

Par ailleurs, la fonction de transfert $g_m$ de l'OTA 1 est, par définition, égale au rapport du courant de sortie $I_{out}$, prélevé par l'intermédiaire du noeud 24, à la tension d'entrée $V_{in}$ appliquée entre les grilles des transistors 15 et 16. La fonction de transfert $g_m$ de l'OTA 1 dépend uniquement des caractéristiques des transistors 15 et 16 et du courant de polarisation $I_b$ de l'OTA délivré par le PTAT 3 :

$$g_m = I_{out}/V_{in} = (2\beta I_b/n_p)^{1/2}.$$

Dans cette équation, np est le facteur de pente et dépend uniquement de la technologie de fabrication, et $\beta$ est le facteur de forme des transistors 15 et 16 et dépend uniquement de leurs dimensions. Dans le mode de réalisation présenté, les transistors 15, 16 et 7, 8 étant identiques, il n'y a qu'un facteur $\beta$ à prendre en compte. Cependant, dans un autre mode de réalisation, les transistors 15 et 16 pourraient être différents des transistors 7 et 8, ce qui introduirait une constante égale à $\beta_1/\beta_2$ dans la suite des calculs et serait sans conséquence sur la précision de la fréquence de coupure obtenue.

En remplaçant le courant $I_b$ par sa valeur selon l'équation (3), la transconductance $g_m$ de l'OTA 1 s'exprime en fonction de $R_{sc}$ et k uniquement.

$$g_m = (2/R_{sc})(k^{1/2}-1).$$

L'équation (2) donne encore :

$$g_m = 2C_{s0}f_{réf}(k^{1/2}-1).$$

La fréquence de coupure du filtre étant donnée par la relation (1), elle s'exprime finalement en fonction de la fréquence de référence, de la constante k et d'un rapport de capacité, où C est la capacité de la charge capacitive 2 associée à l'OTA 1 :

$$fc \propto f_{réf}(k^{1/2}-1)(C_{s0}/C). \qquad (4)$$

Ainsi, il ressort de ces équations que la fréquence de coupure d'un filtre à temps continu réalisé à partir d'OTAs de transconductance $g_m$ et de charges capacitives de capacité C et polarisé par une structure de type PTAT à capacité commutée, s'exprime en fonction d'une fréquence de référence $f_{réf}$ et d'un rapport de capacités. La fréquence de coupure est alors obtenue avec une grande précision grâce à un dispositif simple et robuste.

On notera que la relation (4) a été obtenue pour des transistors 15, 16, 7 et 8 opérant en forte inversion. Un résultat analogue peut être obtenu pour des transistors fonctionnant en faible inversion, par exemple dans des filtres utilisant une très basse tension d'alimentation. Dans ce cas, le courant généré par la structure de polarisation s'exprime simplement en fonction de $n_p$, $R_{sc}$ et une constante $U_T$ appelée potentiel thermodynamique :

$$I_b = (n_pU_T/R_{sc})\ln(k).$$

La transconductance $g_m$ de l'OTA s'écrit, dans ce cas :

5

$$g_m = I_b/(n_p U_T).$$

On démontre alors que la fréquence de coupure $f_c$ est, comme pour un fonctionnement des transistors 15, 16, 7 et 8 en forte inversion, proportionnelle à la fréquence de référence $f_{réf}$ et au rapport de capacités $C_{s0}$ sur C, à une constante ln(k) près:

$$f_c \propto f_{réf} ln(k).(C_{s0}/C).$$

Par conséquent, le fonctionnement en faible inversion conduit à une conclusion similaire à celle obtenue pour le fonctionnement en forte inversion.

La présente description a été faite en se référant à un seul bloc transconducteur. On comprendra aisément que l'invention s'applique aussi à une pluralité de tels blocs, alimentés par la structure de polarisation par l'intermédiaire de miroirs de courant supplémentaires disposés en sortie du transistor 11 appartenant au miroir de courant 4. La flèche en pointillés F indique la manière d'effectuer cette connexion.

L'agencement de plusieurs de ces blocs transconducteurs 1 en association avec des charges capacitives 2 permet de former un filtre de fréquence de coupure $f_c$ vérifiant la relation (4).

**Revendications**

1. Circuit intégré formant un filtre à temps continu agencé pour ajuster une fréquence de coupure $f_c$, comportant

   - au moins un bloc transconducteur (1) de transconductance $g_m$ comprenant une première paire de transistors en régime d'inversion formant l'entrée du filtre,
   - au moins une première charge capacitive (2) de capacité C couplée à la sortie dudit bloc transconducteur (1) formant la sortie du filtre, et
   - une structure de polarisation (3) disposant d'un signal d'horloge de fréquence $f_{réf}$ en entrée, comprenant une structure à capacité commutée avec une seconde charge capacitive de capacité $C_{s0}$, une seconde paire de transistors en régime d'inversion reliés ensemble par leur grille et k transistors identiques actifs, la seconde paire fournissant un courant $I_b$ de polarisation à la première paire de transistors du bloc transducteur,

   ce bloc et la structure de polarisation (3) étant agencés de manière à ce que la fréquence de coupure $f_c$ du filtre à temps continu soit indépendante de la température et du régime d'inversion de la première paire et de la seconde paire de transistors,
   et en ce que ladite fréquence de coupure $f_c$ est fonction uniquement des paramètres suivants:

   - la fréquence $f_{réf}$ en entrée de la structure de polarisation (3),
   - le rapport de capacité $C_{s0}/C$,
   - le nombre k de transistors identiques actifs.

2. Circuit selon la revendication 1, **caractérisé en ce que** la première paire de transistors en régime d'inversion forment deux dispositifs de transconductance (15, 16) identiques, reliés par leurs sources et **en ce que** ledit bloc transconducteur (1) comporte en outre:

   - un premier miroir de courant (18) comprenant une entrée et deux sorties et composé de trois transistors identiques (21, 22, 23), et
   - un deuxième miroir de courant (17) comprenant deux transistors identiques (19, 20).

3. Circuit selon l'une des revendications 1 et 2, **caractérisé en ce que** la seconde paire de transistors en régime d'inversion comprend un premier transistor (7) dont la grille et le drain sont reliés entre eux et un deuxième transistor (8) identique au premier, lesdits transistors de la seconde paire étant reliés par leurs grilles,
   et **en ce que** ladite structure de polarisation (3) comporte en outre:

   - ladite structure à capacité commutée (6) composée de deux transistors (13, 14) identiques dont les grilles sont reliées audit signal d'horloge et de ladite seconde charge capacitive (12) de capacité $C_{s0}$

- un miroir de courant (4) réalisé au moyen d'un premier transistor (10) dont la grille et le drain sont reliés entre eux, d'un deuxième transistor (9) constitué desdits k transistors identiques, agencés pour être, en outre, identiques au premier transistor (10) et d'un troisième transistor (11) identique au premier transistor (10),
- une troisième charge capacitive (5),

**4.** Circuit selon les revendications 2 et 3 **caractérisé en ce que** la première paire et la seconde paire de transistors sont de type PMOS, dimensionnées pour être identiques et fonctionner en régime de forte inversion.

**5.** Circuit selon la revendication 4, **caractérisé en ce que** la fréquence de coupure fc du filtre dépend uniquement de la fréquence de référence $f_{réf}$, dudit nombre k de transistors identiques actifs et du rapport de capacité $C_{s0}/C$ selon l'expression :

$$fc \propto f_{réf}.(k^{1/2}-1).(C_{s0}/C).$$

**6.** Circuit selon la revendication 2 et 3, **caractérisé en ce que** la première paire et la seconde paire de transistors sont de type PMOS et dimensionnées pour être identiques et fonctionner en régime de faible inversion.

**7.** Circuit selon la revendication 6, **caractérisé en ce que** la fréquence de coupure $f_c$ du filtre dépend uniquement de la fréquence de référence $f_{réf}$, dudit nombre k de transistors identiques actifs et du rapport de capacité $C_{s0}/C$ selon l'expression :

$$fc \propto f_{réf}.\ln(k).(C_{s0}/C).$$

**8.** Circuit selon l'une des revendications 1 à 7, **caractérisé en ce qu'**il comporte une pluralité de blocs transconducteurs et de premières charges capacitives couplées à chacun d'eux de manière à former un filtre, lesdits blocs recevant le courant $I_b$ généré par ladite structure de polarisation (3).

**Patentansprüche**

**1.** Integrierter Schaltkreis, der einen zeitkontinuierlichen Filter bildet, der ausgebildet ist, um eine Grenzfrequenz $f_c$ einzustellen, aufweisend:

- mindestens einen Transkonduktorblock (1) mit einer Transkonduktanz $g_m$, umfassend ein erstes Paar Transistoren im Inversionsmodus, als Filtereingang,
- mindestens eine erste kapazitive Last (2) mit der Kapazität C, die an den Ausgang des Transkonduktorblocks (1) gekoppelt ist, als Filterausgang, und
- eine Polarisationsstruktur (3) mit einem Taktsignal mit der Frequenz $f_{réf}$ am Eingang, umfassend eine Schaltkondensatorstruktur mit einer zweiten kapazitiven Last mit der Kapazität $C_{s0}$, ein zweites Paar Transistoren im Inversionsmodus, die anhand ihres Gitters verbunden sind und k aktive identische Transistoren, wobei das zweite Paar an das erste Paar Transistoren des Transduduktorblocks einen Polarisationsstrom $I_b$ liefert,

wobei dieser Block und die Polarisationsstruktur (3) derart ausgebildet sind, dass die Grenzfrequenz $f_c$ des zeitkontinuierlichen Filters unabhängig von der Temperatur und vom Inversionsmodus des ersten Paars und des zweiten Paars Transistoren ist,
und dass die Grenzfrequenz $f_c$ nur von den folgenden Parametern abhängt:

- der Frequenz $f_{réf}$ am Eingang der Polarisationsstruktur (3),
- dem Kapazitätsverhältnis $C_{s0}/C$,
- der Anzahl k aktiver identischer Transistoren.

**2.** Schaltkreis nach Anspruch 1, **dadurch gekennzeichnet, dass** das erste Paar Transistoren im Inversionsmodus zwei identische Transkonduktanzvorrichtungen (15, 16) bildet, die anhand ihrer Zuflüsse verbunden sind und dass der Transkonduktorblock (1) ferner umfasst:

- einen ersten Stromspiegel (18), der einen Eingang und zwei Ausgänge umfasst und aus drei identischen Transistoren (21, 22, 23) zusammengesetzt ist, und
- einen zweiten Stromspiegel (17), der zwei identische Transistoren (19, 20) umfasst.

3. Schaltkreis nach einem der Ansprüche 1 und 2, **dadurch gekennzeichnet, dass** das zweite Paar Transistoren im Inversionsmodus einen ersten Transistor (7), dessen Gitter und Drain miteinander verbunden sind, und einen zweiten Transistor (8), der mit dem ersten identisch ist, umfasst, wobei die Transistoren des zweiten Paars durch ihre Gitter verbunden sind,
und dass die Polarisationsstruktur (3) ferner aufweist:

- die Schaltkondensatorstruktur (6), die aus zwei identischen Transistoren (13, 14), deren Gitter mit dem Taktsignal verbunden sind, und der zweiten kapazitiven Last (12) mit der Kapazität $C_{s0}$ zusammengesetzt ist,
- einen Stromspiegel (4), der aus einem ersten Transistor (10), dessen Gitter und Drain miteinander verbunden sind, einem zweiten Transistor (9), der aus den k identischen Transistoren besteht, die ausgebildet sind, um ferner mit dem ersten Transistor (10) identisch zu sein, und einem dritten Transistor (11), der mit dem ersten Transistor (10) identisch ist, gebildet ist,
- eine dritte kapazitive Last (5).

4. Schaltkreis nach den Ansprüchen 2 und 3, **dadurch gekennzeichnet, dass** das erste Paar und das zweite Paar Transistoren vom Typ PMOS sind, die bemessen sind, um identisch zu sein und um im starken Inversionsmodus zu arbeiten.

5. Schaltkreis nach Anspruch 4, **dadurch gekennzeichnet, dass** die Grenzfrequenz $f_c$ des Filters nur von der Referenzfrequenz $f_{réf}$, von der Anzahl k aktiver identischer Transistoren und vom Kapazitätsverhältnis $C_{s0}/C$ abhängt, gemäß dem Ausdruck:

$$fc \propto f_{réf}.(k^{1/2}-1).(C_{s0}/C).$$

6. Schaltkreis nach Anspruch 2 und 3, **dadurch gekennzeichnet, dass** das erste Paar und das zweite Paar Transistoren vom Typ PMOS sind und bemessen, um identisch zu sein und um im schwachen Inversionsmodus zu arbeiten.

7. Schaltkreis nach Anspruch 6, **dadurch gekennzeichnet, dass** die Grenzfrequenz $f_c$ des Filters nur von der Referenzfrequenz $f_{réf}$, von der Anzahl k aktiver identischer Transistoren und vom Kapazitätsverhältnis $C_{s0}/C$ abhängt, gemäß dem Ausdruck:

$$fc \propto f_{réf}.\ln(k).(C_{s0}/C).$$

8. Schaltkreis nach einem der Ansprüche 1 bis 7, **dadurch gekennzeichnet, dass** er eine Vielzahl von Transkonduktorblöcken und von ersten kapazitiven Lasten aufweist, die jeweils untereinander gekoppelt sind, um einen Filter zu bilden, wobei die Blöcke den von der Polarisationsstruktur (3) erzeugten Strom $I_b$ erhalten.

**Claims**

1. An integrated circuit forming a continuous-time filter arranged to adjust a cutoff frequency $f_c$, including

- at least one transconductor block (1) with transconductance $g_m$ comprising a first pair of transistors in the inversion regime forming the input of the filter,
- at least one first capacitive load (2) with capacitance C coupled to the output of said transconductor block (1) forming the output of the filter, and
- a polarizing structure (3) having a frequency clock signal $f_{ref}$ as input, comprising a capacitance structure switched with a second capacitive load with capacitance $C_{s0}$, a second pair of transistors in the inversion regime connected to one another by their gate, and k active identical transistors, the second pair providing a polarizing current $I_b$ to the first pair of transistors of the transducer block,

this block and the polarizing structure (3) being arranged such that the cutoff frequency $f_c$ of the continuous-time filter is independent of the temperature and the inversion regime of the first pair and the second pair of transistors, and in that the cutoff frequency $f_c$ depends solely on the following parameters:

- the frequency $f_{ref}$ at the input of the polarizing structure (3),
- the capacitance ratio $C_{s0}/C$,
- the number k of active identical transistors.

2. The circuit according to claim 1, **characterized in that** the first pair of transistors in the inversion regime forms two identical transconductance devices (15, 16), connected by their sources, and **in that** said transconductor block (1) further includes:

- a first current mirror (18) comprising an input and two outputs and made up of three identical transistors (21, 22, 23), and
- a second current mirror (17) comprising two identical transistors (19, 20).

3. The circuit according to one of claims 1 and 2, **characterized in that** the second pair of transistors in the inversion regime comprises a first transistor (7) whereof the gate and drain are connected to one another and a second transistor (8) identical to the first, said transistors of the second pair being connected by their gates, and **in that** said polarizing structure (3) further comprises:

- said switched capacitance structure (6) made up of two identical transistors (13, 14) whereof the gates are connected to said clock signal and said second capacitive load (12) with capacitance $C_{s0}$,
- a current mirror (4) made using a first transistor (10) whereof the gate and the drain are connected to one another, a second transistor (9) made up of said k identical transistors, arranged so as to further be identical to the first transistor (10), and a third transistor (11) identical to the first transistor (10),
- a third capacitive load (5).

4. The circuit according to claims 2 and 3, **characterized in that** the first pair and the second pair of transistors are of the PMOS type, sized to be identical and to operate in the strong inversion regime.

5. The circuit according to claim 4, **characterized in that** the cutoff frequency $f_c$ of the filter depends solely on the reference frequency $f_{ref}$, said number k of active identical transistors, and the capacitance ratio $C_{s0}/C$ according to the expression:

$$fc \propto f_{ref.}(k^{1/2}-1).(C_{s0}/C).$$

6. The circuit according to claim 2 and 3, **characterized in that** the first pair and the second pair of transistors are of the PMOS type, and sized to be identical and to operate in the weak inversion regime.

7. The circuit according to claim 6, **characterized in that** the cutoff frequency $f_c$ of the filter depends solely on the reference frequency $f_{ref}$, said number k of active identical transistors, and the capacitance ratio $C_{s0}/C$ according to the expression:

$$fc \propto f_{ref.}\ln(k).(C_{s0}/C).$$

8. The circuit according to one of claims 1 to 7, **characterized in that** it includes a plurality of transconductor blocks and first capacitive loads coupled to each of them so as to form a filter, said blocks receiving the current $I_b$ generated by said polarizing structure (3).

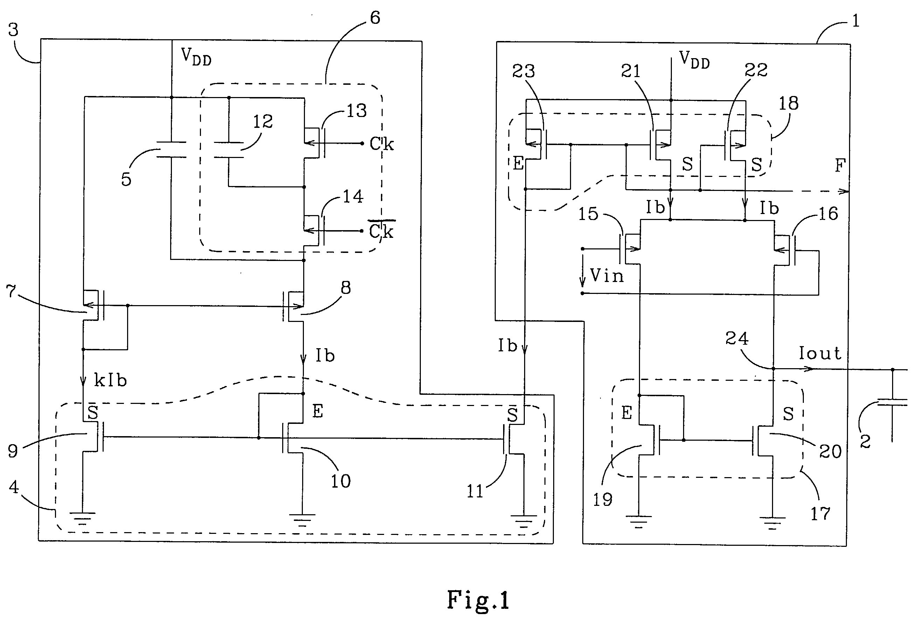

Fig.1

EP 1 679 795 B1